# FASCICULE DE BREVET EUROPEEN

(11) **EP 3 214 701 B1**
(45) Date de publication et mention de la délivrance du brevet: **30.06.2021**
(21) Numéro de dépôt: 17158861.9
(22) Date de dépôt: 02.03.2017
(51) Int. Cl.: H01R 4/48, H01R 11/28, H01R 12/58

(54) **STRUCTURE ÉLECTRIQUE DE RACCORDEMENT D'UNE BARRE CONDUCTRICE À UN COMPOSANT ÉLECTRIQUE**
ELEKTRISCHE VERBINDUNGSSTRUKTUR ZUR VERBINDUNG EINER SAMMELSCHIENE AN EINE ELEKTRISCHE KOMPONENTE
STRUCTURE FOR THE ELECTRICAL CONNECTION OF A BUSBAR TO AN ELECTRICAL COMPONENT

(30) Priorité: 04.03.2016 FR 1651823
(43) Date de publication de la demande: 06.09.2017
(73) Titulaire: Schneider Electric Industries SAS, 92500 Rueil-Malmaison (FR)
(72) Inventeur: BORDONADO, Franck, 38050 GRENOBLE Cedex 9 (FR)
(74) Mandataire: Brevalex

(56) Documents cités:
- WO-A1-2009/010705
- CA-A1- 2 438 678
- DE-A1-102011 121 943
- DE-U1-202009 006 254
- US-A- 4 836 792
- US-A- 5 618 187
- US-A- 5 807 121

## Description

### DOMAINE TECHNIQUE

L'invention se rapporte à un système de connexion mécanique et électrique d'une barre de transmission de courant électrique à un composant électrique.

L'invention se rapporte plus particulièrement à un système de connexion pour un module d'une installation électrique, comportant un transformateur de courant électrique monté sur une platine circuit imprimé, qui est relié à un connecteur du module par des barres conductrices pour la transmission de forts courants.

### ÉTAT DE LA TECHNIQUE ANTÉRIEURE

Un réseau de transport de courant de moyenne tension comporte notamment une cellule de protection constituée d'une pluralité de modules ayant des fonctions différentes telles que par exemple les fonctions Entrées/Sorties, Alimentation, Communication ou Acquisition Courant/Tension. Cela permet d'offrir une grande diversité d'applications pour les réseaux moyenne tension.

L'un de ces modules, qui est le module d'acquisition courant/tension consiste en une installation électrique comportant, en tant que composants principaux : un transformateur d'acquisition de courant (CT Current Transformer), un connecteur client qui permet de raccorder le primaire du transformateur, une chaine de conversion analogique et un connecteur de liaison vers la carte mère. Ces composants sont montés sur une platine circuit imprimé (printed circuit board en anglais).

Le circuit primaire du transformateur est traversé par un courant de forte intensité. Cela implique d'utiliser des conducteurs de section importante pour réaliser ce circuit.

Le câblage du module à l'aide de conducteurs sous la forme de fils électriques est réalisé manuellement par un opérateur, ce qui implique un risque d'erreur, ainsi qu'une complexité du cheminement des câbles influant sur la performance du module, notamment pour des problèmes dits de diaphonie.

De plus, un tel mode de câblage a un coût qui augmente avec la complexité de l'opération.

Le raccordement des composants par des barres conductrices implique de plier chaque barre au fur et à mesure du câblage.

Aussi, la rigidité des barres rend leur raccordement au transformateur difficile et techniquement complexe dans sa réalisation pratique, sans garantir systématiquement de liaison mécanique.

Les documents US-5.618.187, WO-2009/010705 et US-4.836.792 décrivent des systèmes de connexion selon l'état de la technique.

L'invention a pour but de proposer un système de connexion mécanique et électrique d'une barre conductrice à tout autre composant électrique, tel que le transformateur de courant, qui est simple à mettre en œuvre et qui assure des connexions mécanique et électrique fiables.

### EXPOSÉ DE L'INVENTION

L'invention concerne un système de connexion mécanique et électrique comportant que défini dans la revendication 1.

La combinaison des deux orifices de la platine, qui coopèrent chacun avec la barre ou avec la patte du composant électrique et la pince de la barre conductrice permet d'avoir une liaison à la fois mécanique et électrique de la barre avec le composant électrique qui est sûre et efficace.

De préférence, la pince comporte une partie inférieure qui est reçue dans le deuxième orifice avec la patte du composant.

De préférence, la platine comporte une couche de matériau conducteur continue formée au niveau des orifices et qui recouvre au moins une face inférieure de la platine, en entourant les ouvertures des orifices, et qui peut recouvrir aussi la face supérieure de la platine et les parois des orifices.

De préférence, une partie de la couche de matériau conducteur, qui recouvre une face inférieure de la platine est recouverte d'un matériau de brasure.

De préférence, la pince est constituée d'au moins deux crochets délimitant conjointement un logement cylindrique et sont aptes à s'écarter lorsque la patte est introduite dans ledit logement.

De préférence, chaque crochet comporte au moins une languette s'étendant parallèlement à l'axe principal du logement, dont l'extrémité inférieure de chaque languette est située verticalement au-dessous d'une face inférieure de la platine et fait saillie vers l'extérieur par rapport au crochet.

De préférence, la barre conductrice est constituée de deux demi-barres qui sont réparties de part et d'autre d'un plan longitudinal vertical médian de la barre et qui sont reliées l'une à l'autre au niveau de leur bord d'extrémité supérieur par une ligne de pliage.

De préférence, chaque demi-barre comporte un crochet et une moitié du pied.

De préférence, la ligne de pliage forme une ligne discontinue et comporte une pluralité de fenêtres réparties longitudinalement le long de la ligne de pliage.

De préférence, la barre conductrice est réalisée par pliage d'un flan en matériau conducteur qui a été préalablement découpé et embouti.

### BRÈVE DESCRIPTION DES DESSINS

D'autres caractéristiques et avantages de l'invention apparaîtront à la lecture de la description détaillée qui suit pour la compréhension de laquelle on se reportera aux figures annexées parmi lesquelles :
- la figure 1 est une représentation schématique d'un module comportant un composant et une barre de raccordement reliés selon la structure électrique selon l'invention ;
- la figure 2 est un détail en perspective d'une partie du module représenté à la figure 1, montrant la structure selon l'invention ;
- la figure 3 est un éclaté à plus grande échelle du détail représenté à la figure 2, montrant les différents composants de la structure électrique avant leur assemblage ;
- la figure 4 est une section selon un plan longitudinal vertical de la structure électrique assemblée ;
- les figures 5 et 6 sont des représentations schématiques d'une variante de réalisation de l'invention dans laquelle la pince porte des pattes de verrouillage ;
- la figure 7 est une représentation schématique d'une partie du module montrant des barres conductrices recouvertes par une couche de matière isolante ;
- les figures 8A à 8C sont des vues montrant différentes étapes de fabrication de la barre conductrice ;
- la figure 9 est une vue similaire à celle de la figure 8C, montrant une variante de réalisation de la barre conductrice.

### EXPOSÉ DÉTAILLÉ DE MODES DE RÉALISATION PARTICULIERS

Pour la description de l'invention, on adoptera à titre non limitatif les orientations verticale, longitudinale et transversale selon le repère V, L, T indiqué aux figures.

Dans la description qui va suivre, des éléments identiques, similaires ou analogues seront désignés par les mêmes chiffres de référence.

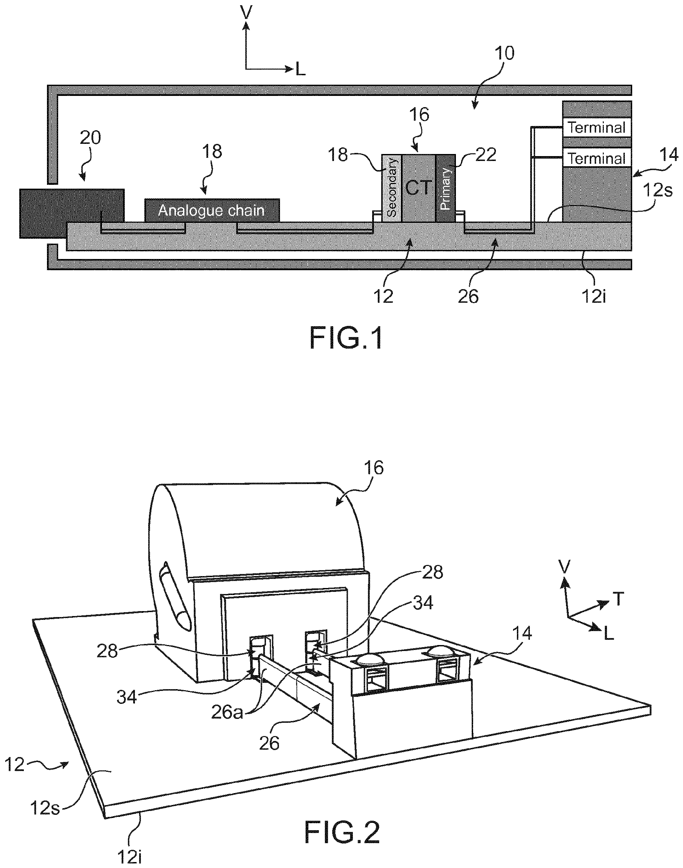

On a représenté à la figure 1 un module 10 pour une cellule de protection destinée à être installée dans une ligne de transport de courant à moyenne tension. Ce module 10 est par exemple un module d'acquisition courant/tension.

Le module 10 comporte une platine circuit imprimé12 sur laquelle de nombreux composants électroniques sont montés.

Dans la description qui va suivre, on considèrera que la platine 12 s'étend selon un plan principal horizontal avec la direction longitudinale d'avant en arrière étant la direction de droite à gauche en se reportant à la figure 1.

Le module 10 comporte ici un connecteur avant 14 pour le montage et le raccordement du module 10 dans la cellule, un transformateur 16 d'acquisition de courant, une chaine de conversion analogique 18 et un connecteur arrière 20 de raccordement du module 10 à une carte mère de la cellule.

Le transformateur 16 comporte un circuit primaire 22 qui est raccordé au connecteur avant 14 et un circuit secondaire 24 raccordé à la chaine de conversion analogique 18. Le courant qui circule entre le connecteur avant 14 et le circuit primaire 22 est issu directement du circuit secondaire d'un autre transformateur de courant (non représenté) installé dans la cellule et est transporté par des conducteurs 26.

Les différents composants du module 10 sont ici représentés comme étant montés sur une même face supérieure 12s de la platine, sa face inférieure 12i étant vide.

Il sera compris que le module 10 peut comporter d'autres composants montés sur cette face inférieure 12i de la platine 12, en plus de ceux montés sur sa face supérieure 12s.

L'intensité de ce courant peut présenter des pics importants, de l'ordre de plusieurs dizaines d'ampères, que les conducteurs 26 doivent être capables de supporter.

Comme on peut le voir aux figures 2 et suivantes, chaque conducteur 26 consiste en une barre dont la section est de forme principale rectangulaire, la grande longueur de sa section étant verticale.

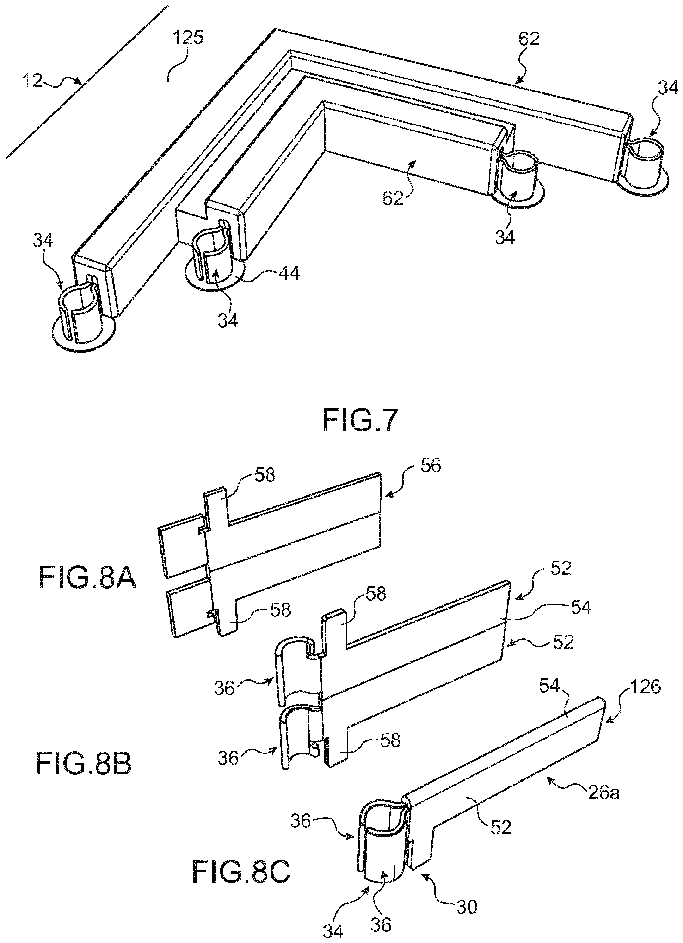

Selon le mode de réalisation représenté à la figure 2, chaque barre 26 s'étend longitudinalement. Il sera compris que l'invention n'est pas limitée à cette configuration des barres 26, qui peuvent être pliée selon différents angles, comme représenté par exemple à la figure 7.

Chaque extrémité d'une barre 26 est reliée à un composant du module 10, c'est-à-dire ici une première extrémité longitudinale 26a de la barre 26 est reliée au transformateur 16, la deuxième extrémité 26b de la barre 26 est reliée au connecteur avant 14.

Dans la description qui va suivre, on fera référence à un système réalisant le raccordement de la première extrémité 26a d'une barre 26 au transformateur 16. Il sera compris que cette description peut s'appliquer aussi à la liaison de la première extrémité 26a ou la deuxième extrémité 26b d'une barre 26 avec un autre composant électrique du module 10. Ce composant électrique pouvant aussi être un composant électronique.

Aussi, à titre de simplification de la description, on considèrera que la première extrémité 26a de la barre 26 est orientée longitudinalement. Il sera compris que cette orientation n'est pas limitative et qu'une extrémité d'une barre 26 peut être orientée différemment sans sortir du domaine de l'invention, tout en restant parallèle au plan principal de la platine 12.

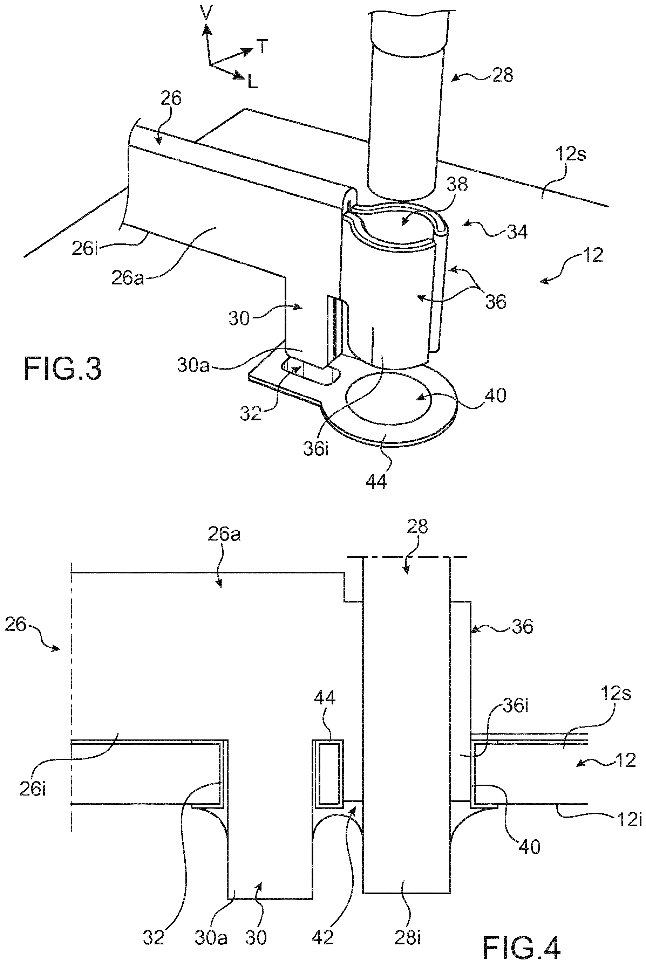

Comme on peut le voir plus en détails à la figure 3, pour sa liaison avec la barre 26, le composant électrique, qui est ici le transformateur 16, comporte une patte 28 de raccordement.

Cette patte 28 est de forme cylindrique de révolution et son axe principal est vertical perpendiculaire au plan horizontal de la platine 12.

L'extrémité 26a de la barre 26 est réalisée pour mettre en œuvre sa liaison mécanique avec la patte 28 et avec la platine 12, ainsi que pour réaliser le raccordement électrique de la barre 26 avec la patte 28.

La liaison mécanique de l'extrémité 26a de la barre 26 avec la platine 12 est réalisée par un pied 30 qui s'étend verticalement vers le bas depuis un bord inférieur 26i de la barre 26. Le pied 30 est introduit dans un premier orifice 32 complémentaire formé dans la platine 12.

De préférence, la longueur verticale du pied 30 est supérieure à l'épaisseur de la platine 12.

Ainsi, lorsque la barre 26 est en position sur la platine 12, l'extrémité inférieure libre 30a du pied 30 fait saillie verticalement vers le bas par rapport à la face inférieure 12i de la platine 12.

Cette partie en saillie permet d'offrir une surface de contact disponible pour l'application de brasure afin notamment de fixer la barre 26 sur la platine 12.

La liaison mécanique de l'extrémité 26a de la barre 26 avec la patte 28 est réalisée par une pince 34 qui est située en bout de l'extrémité 26a de la barre 26 et qui reçoit la patte 28.

De préférence, la pince 34 est déformable élastiquement, pour réaliser un serrage de la patte 28.

Pour cela, la pince 34 est constituée de deux crochets 36, qui prolongent longitudinalement l'extrémité 26a de la barre 26 et dont les extrémités longitudinales libres des crochets 36 sont distantes transversalement l'une de l'autre.

Selon le mode de réalisation représenté aux figures, les crochets 36 sont agencés symétriquement l'un par rapport à l'autre par rapport à un plan longitudinal vertical médian de l'extrémité 26a de la barre 26.

Il sera compris que l'invention n'est pas limitée à ce mode de réalisation de la pince 34, qui peut comporter un nombre différent de crochets 36 ou bien les crochets 36 peuvent ne pas être symétriques par rapport au plan principal médian de l'extrémité 26a de la barre 26.

Lorsque la pince 34 est vide, comme c'est notamment le cas dans la vue de la figure 3, la dimension transversale du logement 38 défini par la pince 34 est inférieure à la largeur transversale de la patte 28, c'est-à-dire inférieure au diamètre de la patte 28. Ainsi, lorsque la patte 28 est introduite dans la pince 34, elle provoque un écartement des deux crochets 36 selon la direction transversale.

Cet écartement des crochets 36 est limité par le diamètre de l'orifice 40, c'est dire que les crochets 36 viennent en butée contre la face interne de l'orifice 40.

La patte 28 est ainsi montée à force dans le logement 38.

Il en résulte que le jeu d'assemblage résiduel entre l'orifice 40, les crochets 36 et la patte 28est quasiment nul, ce qui permet de conserver en permanence un appui des crochets 36 sur la patte 28.

Cet appui permet de réaliser une liaison mécanique de la patte 28 avec l'extrémité 26a de la barre 26, ainsi qu'une liaison électrique puisque la pince 34 est réalisée d'une seule pièce avec l'extrémité 26a de la barre 26, en un matériau conducteur électrique.

Selon un autre aspect de la liaison de l'extrémité 26a de la barre 26 avec la patte 28, permettant de maintenir cette liaison, la platine 12 comporte un deuxième orifice 40 dans lequel la patte 28 est reçue.

Selon un mode de réalisation préféré, une partie de la pince 34 est aussi reçue dans cet orifice, avec la patte 28.

A cet effet, chaque crochet 36 de la pince 34 s'étend verticalement vers le bas au-delà du bord inférieur 26i de l'extrémité 26a de la barre 26 et l'extrémité inférieure 36i de chaque crochet 36 est reçue dans le deuxième orifice 40.

Aussi, la patte 28 est insérée dans la pince 34 et dans le deuxième orifice 40 pour que son extrémité inférieure 28i soit en saillie verticalement vers le bas par rapport à la face inférieure 12i de la platine 12. Cette partie de la patte 28 qui est en saillie est disponible pour être recouverte par une couche de brasure qui permet de fixer ensemble la patte 28, la platine 12 et la pince 34.

De préférence, le diamètre du deuxième orifice 40 est sensiblement égal au diamètre extérieur de la pince 34 lorsque qu'elle reçoit la patte 28.

Ainsi, lorsque l'on introduit la patte 28 dans la pince 34, après avoir préalablement monté l'extrémité 26a de la barre 26 sur la platine, les crochets 36 s'écartent l'un de l'autre et viennent en appui contre les parois internes du deuxième orifice 40.

Cela participe au serrage de la patte 28 par la pince 34.

Selon un autre aspect de la structure d'assemblage, que l'on peut voir à la figure 4, une couche continue de brasure 42 est déposée sur la face inférieure 12i de la platine 12. Cette couche de brasure 42 recouvre à la fois le pied 30 de l'extrémité 26a de la barre 26 et l'extrémité inférieure 28i de la patte 28.

Ici, la couche de brasure 42 est aussi en contact avec l'extrémité inférieure 36i de chaque crochet 36.

La couche de brasure 42 est, de manière connue, réalisée en un matériau conducteur électrique.

Cette couche de brasure 42 réalise donc la fixation du pied 30 (et donc de l'extrémité 26a de la barre 26) et de la patte 28 sur la platine 12. Cette liaison mécanique indirecte de l'extrémité 26a de la barre 26 avec la patte 28 complète la liaison mécanique de l'extrémité 26a de la barre 26 avec la patte 28 par l'intermédiaire de la pince 34.

La couche de brasure réalise aussi une deuxième liaison électrique de l'extrémité 26a de la barre 26 avec la patte 28, qui complète la liaison électrique de l'extrémité 26a de la barre 26 avec la patte 28 réalisée au niveau de la pince 34.

Afin d'améliorer encore la liaison électrique entre l'extrémité 26a de la barre 26 et la patte 28, la platine 12 comporte une couche continue de matériau conducteur 44 qui recouvre la face inférieure 12i de la platine 12, qui entoure les ouvertures du premier orifice 32 et du deuxième orifice 40. A titre de variante, la couche de matériau conducteur 44 recouvre aussi la paroi cylindrique intérieure du premier orifice 32, la paroi cylindrique intérieure du deuxième orifice 40, ainsi qu'une partie de la face supérieure 12s de la platine 12.

Cette couche de matériau conducteur 44 est alors simultanément en contact électrique avec l'extrémité 26a de la barre 26, son pied 30, les crochets 36 de la pince 34 et la couche de brasure 42.

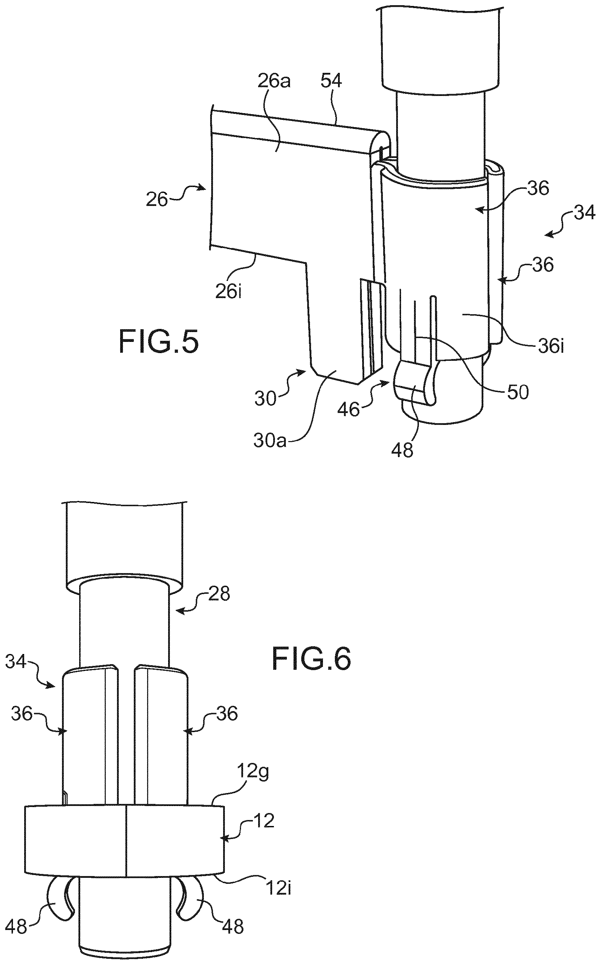

On a représenté aux figures 5 et 6 une variante de réalisation de la barre conductrice selon laquelle la pince 34 comporte des languettes de verrouillage 46 de l'extrémité 26a de la barre 26 sur la platine 12.

Chaque languette de verrouillage 46 s'étend verticalement vers le bas depuis un crochet 36 de la pince 34 et l'extrémité inférieure libre 48 de chaque languette de verrouillage 46 est recourbée pour faire saillie transversalement vers l'extérieur par rapport au crochet 36 associé, comme on peut le voir plus particulièrement à la figure 6.

Chaque languette de verrouillage 46 comporte un bras vertical 50 reliant l'extrémité inférieure 48 de la languette de verrouillage 46 au reste du crochet 36, qui est de préférence réalisé par découpe ou défonce du bras 50.

Lors du montage de l'extrémité 26a de la barre 26 sur la platine 12, les languettes de verrouillage 46 se déforment transversalement vers l'intérieur du logement 38, pour permettre le passage de la pince 34 au travers du deuxième orifice 40.

Ensuite, les languettes de verrouillage 46 reprennent leur forme initiale par rapport aux crochets 36.

Comme on peut le voir à la figure 6, lorsque la barre 26 est en position montée sur la platine 12, les extrémités inférieures 48 des languettes de verrouillage 46 sont situées au-dessous de la face inférieure 12i de la platine 12.

Ensuite, la patte 28 du composant est introduite dans la pince 34.

A partir de cet instant, la patte 28 du composant empêche aux languettes de verrouillage 46 de se déformer transversalement vers l'intérieur du logement 38.

Les languettes de verrouillage 46 viennent alors en butée vers le haut contre la face inférieure 12i de la platine 12 lorsque l'extrémité 26a de la barre 26 est tirée vers le haut, empêchant ainsi l'extrémité 26a de la barre 26 de se déplacer vers le haut.

Selon un mode de réalisation préféré, chaque barre 26 est réalisée à partir de deux demi-barres 52 symétriques et parallèles, qui sont accolées l'une contre l'autre par leurs faces verticales en vis-à-vis et qui sont reliées par leurs bords supérieurs respectifs.

Ainsi, lorsque la barre 26 est rectiligne, ou avant son pliage sur la platine 12, comme c'est le cas notamment selon le mode représenté à la figure 3, les deux demi-barres 52 sont symétriques par rapport à un plan longitudinal vertical médian de la barre 26 et sont accolées l'une à l'autre par leurs faces verticales longitudinales en vis-à-vis.

Selon une variante, un léger jeu transversal est présent entre les deux demi-barres 52. Ce jeu permet une circulation d'air entre les demi-barres 52 et améliore par conséquent le refroidissement de la barre 26.

Les deux demi-barres 52 sont reliées entre elles à leur bord supérieur longitudinal par une ligne de pliage 54.

Comme on peut le voir aux figures 8A à 8C, selon un mode de réalisation préféré de cette variante, la barre 26 est réalisée par découpe et pliage, ou défonçage, d'une plaque en matériau conducteur.

Ainsi, selon une première étape représentée par la figure 8A, un flan 56 est formé par découpe de la plaque de tôle. Ce flan est symétrique par rapport à une ligne longitudinale qui deviendra la ligne de pliage 54. Les deux parties du flan 56 situées de part et d'autre de la ligne longitudinale sont destinées à former les demi-barres 52.

Ce flan comporte déjà deux parties 58 destinées à former le pied 30.

Ensuite, selon une deuxième étape représentée par la figure 8B, le flan 56 est soumis à emboutissage, notamment pour mettre en forme les crochets 36. Les deux demi-barres 52 sont alors formées et sont réparties de part et d'autre de la ligne de pliage 54.

Enfin, selon une troisième étape représentée par la figure 8C la barre 26 est formée par pliage de la pièce obtenue à l'issue de la deuxième étape, le long de la ligne de pliage 54.

Les deux demi barres 52 sont alors accolées l'une contre l'autre, les deux crochets sont associés pour former la pince 34 et le pied 30 est lui aussi formé.

Il sera compris que cette méthode de réalisation d'une barre 26 s'appliquerait à l'identique pour une barre dans laquelle les crochets 36 comportent des languettes de verrouillage 46.

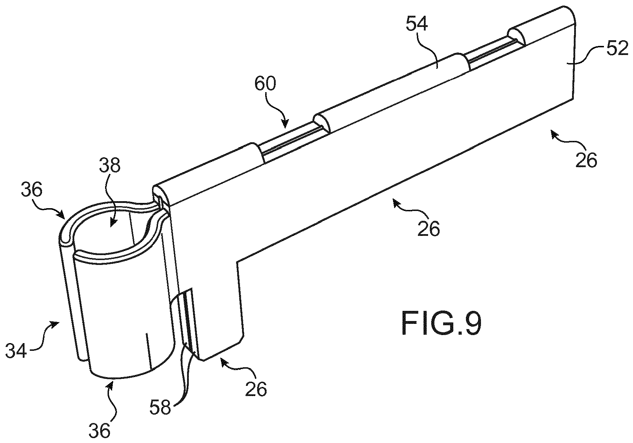

Afin de faciliter l'opération de pliage, et selon un autre aspect de cette méthode de fabrication de la barre 26 représenté à la figure 9, la ligne de pliage 54 est interrompue, c'est-à-dire qu'elle comporte une pluralité de fenêtres 60 réparties le long de la ligne de pliage 54.

Des moyens d'isolation de chaque barre 26 peuvent être mis en place sur le module, notamment afin de protéger le module 10 contre tout court-circuit. Cette étape peut être réalisée avant ou après mise en place de la barre 26 sur la platine 12.

Pour cela, comme on peut le voir à la figure 7, chaque barre 26 est recouverte d'un isolateur 62, qui est de préférence réalisé par surmoulage afin d'être adapté au mieux à la forme de la barre 26.

## Revendications

1. Système de connexion mécanique et électrique comportant une platine circuit imprimé (12), une barre conductrice (26) et un composant électrique (16),
dans lequel la platine comporte un premier orifice (32) dans lequel un pied (30) inférieur de la barre (26) est reçu et comporte un deuxième orifice (40) dans lequel une patte (28) du composant (16) est reçue,
et dans lequel la barre (26) comporte une pince (34) déformable élastiquement qui reçoit la patte (28) du composant (16),
**caractérisé en ce que** la pince (34) est constituée d'au moins deux crochets (36) délimitant conjointement un logement cylindrique (38) qui sont aptes à s'écarter lorsque la patte (28) est introduite dans ledit logement (28).
et **en ce que** chaque crochet (36) comporte une partie inférieure (36i) qui est reçue dans le deuxième orifice (40) avec la patte (28) du composant (16).

2. Système selon l'une quelconque des revendications précédentes, **caractérisé en ce que** la platine (12) comporte une couche (44) de matériau conducteur continue formée au niveau des orifices (32, 40) et qui qui recouvre au moins une face inférieure (12i) de la platine (12), en entourant les ouvertures des orifices (32, 40).

3. Système selon la revendication 2, **caractérisé en ce qu'**une partie de la couche (44) de matériau conducteur, qui recouvre une face inférieure (12i) de la platine (12) est recouverte d'un matériau de brasure.

4. Système selon l'une quelconque des revendications précédentes, **caractérisé en ce que** chaque crochet (36) comporte au moins une languette (46) s'étendant parallèlement à l'axe principal du logement (28), dont l'extrémité inférieure (48) de chaque languette est située verticalement au-dessous d'une face inférieure (12i) de la platine (12) et fait saillie vers l'extérieur par rapport au crochet (36).

5. Système selon l'une quelconque des revendications précédentes, **caractérisé en ce que** la barre (26) conductrice est constituée de deux demi-barres (52) qui sont réparties de part et d'autre d'un plan longitudinal vertical médian de la barre (26) et qui sont reliées l'une à l'autre au niveau de leur bord d'extrémité supérieur par une ligne de pliage (54).

6. Système selon la revendication 5, **caractérisé en ce que** chaque demi-barre (52) comporte un crochet (36) et une moitié (58) du pied (30).

7. Système selon la revendication 5, **caractérisé en ce que** la ligne de pliage (54) forme une ligne discontinue et comporte une pluralité de fenêtres (60) réparties longitudinalement le long de la ligne de pliage (54).

8. Système selon l'une quelconque des revendications 5 à 7, **caractérisé en ce que** la barre (26) conductrice est réalisée par pliage d'un flan (56) en matériau conducteur qui a été préalablement découpé et embouti.

## Patentansprüche

1. Mechanisches und elektrisches Verbindungssystem, enthaltend eine Leiterplatte (12), eine Stromschiene (26) und ein elektrisches Bauteil (16),
wobei die Leiterplatte eine erste Öffnung (32) aufweist, in der ein unterer Fuß (30) der Schiene (26) aufgenommen ist, sowie eine zweite Öffnung (40), in der eine Lasche (28) des Bauteils (16) aufgenommen ist,
und wobei die Schiene (26) eine elastisch verformbare Klammer (34) aufweist, die die Lasche (28) des Bauteils (16) aufnimmt,
**dadurch gekennzeichnet, dass** die Klammer (34) aus zumindest zwei Haken (36) besteht, die gemeinsam eine zylindrische Aufnahme (38) begrenzen und sich beim Einführen der Lasche (28) in die Aufnahme (28) auseinander bewegen können,
und dass jeder Haken (36) einen unteren Abschnitt (36i) aufweist, der mit der Lasche (28) des Bauteils (16) in der zweiten Öffnung (40) aufgenommen ist.

2. System nach dem vorhergehenden Anspruch,
**dadurch gekennzeichnet, dass** die Leiterplatte (12) eine durchgehende Schicht (44) aus leitfähigem Material aufweist, die im Bereich der Öffnungen (32, 40) ausgebildet ist und zumindest eine Unterseite (12i) der Leiterplatte (12) bedeckt und dabei die Mündungen der Öffnungen (32, 40) umgibt.

3. System nach Anspruch 2,
**dadurch gekennzeichnet, dass** ein Teil der Schicht (44) aus leitfähigem Material, der eine Unterseite (12i) der Leiterplatte (12) bedeckt, mit einem Lötmaterial bedeckt ist.

4. System nach einem der vorhergehenden Ansprüche,
**dadurch gekennzeichnet, dass** jeder Haken (36) zumindest eine parallel zur Hauptachse der Aufnahme (28) verlaufende Zunge (46) aufweist, wobei das untere Ende (48) jeder Zunge vertikal unter einer Unterseite (12i) der Leiterplatte (12) liegt und in Bezug auf den Haken (36) nach außen vorsteht.

5. System nach einem der vorhergehenden Ansprüche,
**dadurch gekennzeichnet, dass** die Stromschiene (26) aus zwei Halbschienen (52) besteht, die auf beiden Seiten einer vertikalen Mittellängsebene der Schiene (26) verteilt sind und im Bereich ihrer oberen Endkante durch eine Biegelinie (54) miteinander verbunden sind.

6. System nach Anspruch 5,
**dadurch gekennzeichnet, dass** jede Halbschiene (52) einen Haken (36) und eine Hälfte (58) des Fußes (30) umfasst.

7. System nach Anspruch 5,
**dadurch gekennzeichnet, dass** die Biegelinie (54) eine diskontinuierliche Linie bildet und eine Mehrzahl von Fenstern (60) aufweist, die in Längsrichtung entlang der Biegelinie (54) verteilt sind.

8. System nach einem der Ansprüche 5 bis 7,
**dadurch gekennzeichnet, dass** die Stromschiene (26) durch Umbiegen eines Zuschnitts (56) aus leitendem Material hergestellt ist, der zuvor ausgestanzt und umgeformt wurde.

## Claims

1. A mechanical and electrical connection system including a printed circuit board (12), a conductor bar (26) and an electrical component (16),
wherein the board includes a first orifice (32) into which a lower leg (30) of the bar (26) is accommodated and includes a second orifice (40) into which a leg (28) of the component (16) is accommodated,
and wherein the bar (26) includes an elastically-deformable clamp (34) which accommodates the leg (28) of the component (16),
**characterized in that** the clamp (34) consists of at least two hooks (36) delimiting together a cylindrical housing (38) which are adapted to move away from one another when the leg (28) is introduced into said housing (28),
and **in that** each hook (36) includes a lower portion (36i) which is accommodated into the second orifice (40) with the leg (28) of the component (16).

2. The system according to any one of the preceding claims, **characterized in that** the board (12) includes a continuous layer (44) of a conductive material formed at the orifices (32, 40) and which covers at least one lower face (12i) of the board (12), by surrounding the openings of the orifices (32, 40).

3. The system according to claim 2, **characterized in that** a portion of the conductive material layer (44), which covers a lower face (12i) of the board (12), is covered with a soldering material.

4. The system according to any one of the preceding claims, **characterized in that** each hook (36) includes at least one tab (46) extending parallel to the main axis of the housing (28), the lower end (48) of each tab of which is located vertically beneath a lower face (12i) of the board (12) and projects outwardly with respect to the hook (36).

5. The system according to any one of the preceding claims, **characterized in that** the conductor bar (26) consists of two half-bars (52) which are distributed on either side of a vertical longitudinal midplane of the bar (26) and which are linked to one another at their upper end edge by a fold line (54).

6. The system according to claim 5, **characterized in that** each half-bar (52) includes a hook (36) and one half (58) of the leg (30).

7. The system according to claim 5, **characterized in that** the fold line (54) forms a discontinuous line and includes a plurality of windows (60) distributed longitudinally along the fold line (54).

8. The system according to any one of claims 5 to 7, **characterized in that** the conductor bar (26) is made by folding a blank (56) made of a conductive material which has been cut and stamped beforehand.
